Europäisches Patentamt

European Patent Office

Office européen des brevets

(11) Veröffentlichungsnummer : **0 571 365 B1**

(12) **EUROPÄISCHE PATENTSCHRIFT**

(45) Veröffentlichungstag der Patentschrift :
26.10.94 Patentblatt 94/43

(51) Int. Cl.⁵ : **H03H 9/64, H03H 9/02**

(21) Anmeldenummer : **90916031.9**

(22) Anmeldetag : **14.11.90**

(86) Internationale Anmeldenummer :
**PCT/DE90/00876**

(87) Internationale Veröffentlichungsnummer :
**WO 91/07818 30.05.91 Gazette 91/12**

(54) **OBERFLÄCHENWELLEN-REFLEKTORFILTER.**

(30) Priorität : **14.11.89 DE 3937871**
**12.06.90 DE 4018784**

(43) Veröffentlichungstag der Anmeldung :
**01.12.93 Patentblatt 93/48**

(45) Bekanntmachung des Hinweises auf die
Patenterteilung :
**26.10.94 Patentblatt 94/43**

(84) Benannte Vertragsstaaten :
**AT BE CH DE DK ES FR GB IT LI NL SE**

(56) Entgegenhaltungen :
**EP-A- 0 032 313**
**EP-A- 0 054 723**
**US-A- 3 559 115**

(56) Entgegenhaltungen :
**The IEEE 15th conference of Electrical and
Electronics Engineers in Israel, Proceedings,
7-9 April 1987, Tel Aviv Fair Grounds Z. Ovnat:
"A low-loss narrowband surface acoustic
wave filter at UHF is realized with two-track
group-type unidirectional transducers", Seiten 1-4 siehe Zusammenfassung; Seite 1,
Zeile 13 - Seite 2, Zeile 37; Figuren 1,3.
Patent Abstracts of Japan Band 8, Nr. 268, 7
Dezember 1984**

(73) Patentinhaber : **SIEMENS
AKTIENGESELLSCHAFT
Wittelsbacherplatz 2
D-80333 München (DE)**

(72) Erfinder : **MACHUI, Jürgen
Strassbergerstrasse 103
D-8000 München 40 (DE)**
Erfinder : **RUILE, Werner
Klarastrasse 5
D-8000 München 19 (DE)**

Anmerkung : Innerhalb von neun Monaten nach der Bekanntmachung des Hinweises auf die Erteilung des europäischen Patents kann jedermann beim Europäischen Patentamt gegen das erteilte europä- ische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patent- übereinkommen).

**Beschreibung**

Die vorliegende Erfindung bezieht sich auf ein mit akustischen Oberflächenwellen arbeitendes Reflektorfilter mit einem Eingangswandler, einem Ausgangswandler und mit Reflektorstrukturen, die für den Weg akustischer Oberflächenwellen zwischen Eingangswandler und Ausgangswandler in Reihe hintereinandergeschaltet wirksam sind und die diese akustischen Wellen zwischen Eingangswandler und Ausgangswandler in ihrer Richtung mehrmals umlenken.

Aus den Druckschriften US-A-4 484 160 und 4 520 330 ist ein als RAC-Filter bezeichnetes Reflektor-Oberflächenwellenfilter mit einem Eingangswandler, einem Ausgangswandler und zwei Reflektorstrukturen bekannt, die mit schräggestellten Reflektorfingern sich (nebeneinander liegend) derart gegenüberstehen,. daß eine in den einen Reflektor hineinlaufende akustische Welle um etwa 90° umgelenkt in den anderen Reflektor gelangt und von letzterem wiederum mit etwa 90° Richtungsänderung dem Ausgangswandler zugeführt wird. Ein solches Filter eignet sich für die Verwendung als Zeitfenster. Die Fingerstrukturen der erwähnten Reflektoren können der gewünschten Übertragungsfunktion entsprechend gewichtet und/oder dispersiv sein. Als Fingerwichtung kann insbesondere Fingerverschiebungswichtung, Fingerweglaßwichtung und Fingerdrehung vorgesehen sein. Ein solches bekanntes Reflektorfilter hat zwei akustische Spuren, nämlich die eine Spur mit dem Eingangswandler und dem einen Reflektor und die parallel dazu laufende zweite Spur mit dem anderen Reflektor und dem Ausgangswandler. Die Spuren fallen zusammen mit der jeweiligen Haupt-Wellenausbreitungsrichtung des zur betreffenden Spur gehörigen Wandlers.

Nachteile eines solchen Reflektorfilters sind eine gewisse Temperaturabhängigkeit der Winkelgenauigkeit der Reflexion, und zwar auch bei einem Substrat aus Quarz, und ein gewisses Maß an Übertragungsverlusten. Ein solches Reflektorfilter benötigt aber nur ein Minimum an Größe des Substrats, nachdem die Breite eines dort in Frage kommenden länglichen Substratplättchens aus Stabilitätsgründen ohnehin nicht so klein gemacht werden könnte, wie sie z.B. für eine in-line-Anordnung, lediglich den Platzbedarf für die Struktur betrachtet, gemacht werden könnte. Die Selektivität eines solchen Filters ist im wesentlichen durch die akustisch wirksame Länge der Reflektoren gegeben.

In der EP-A-00 32 313 sind Filterstrukturen beschrieben, die jeweils verringerte Temperaturempfindlichkeit trotz abgewinkelten akustischen Weges aufweisen. Es ist dort zu diesem Zweck jeweils ein Trio vom Reflektoren mit Winkeländerung des akustischen Weges vorgesehen. Wichtig ist für diese Filterstrukturen, daß für den mittleren Reflektor dieses Trios Einfallswinkel und Ausfallswinkel der Welle gleich groß sind. An die Größe der jeweiligen Richtungsänderung sind keine Anforderungen gestellt und sie liegen bei oder wenigstens nahe 90°.

In IEEE Trans. Ultrasonics, Bd. 35 (1988) S. 61 ff. sind Ausführungsformen mehrspuriger Reflektorfilter mit Multistrip-Kopplern angegeben. Eine weitere, andere dort angegebene Ausführungsform sieht ein Filter mit Eingangswandler, Ausgangswandler und zwei Reflektorstrukturen vor, die in-line zueinander angeordnet sind. Es liegen zwei voneinander unabhängige Wege der akustischen Welle zwischen dem Eingangswandler und dem Ausgangswandler vor. In jedem dieser Wege ist nur ein Reflektor für spitzwinklige Reflexion der jeweils einen Welle eingefügt. Temperaturkompensation der Reflexionswinkel liegt nicht vor.

Aufgabe der vorliegenden Erfindung ist es, ein mit akustischen Oberflächenwellen arbeitendes Reflektorfilter anzugeben, das bei, bezogen auf die vorgegebenen Anforderungen bezüglich Selektivität, möglichst geringer Größe des notwendigen Substratkörpers ein Optimum an Temperaturunabhängigkeit seiner Eigenschaften, eingeschlossen die Reflexion, aufweist und ggf. dabei auch ein Minimum an Verlust an Signalenergie (low loss) hat. Insbesondere soll das Filter auch geringes akustisches Übersprechen haben.

Diese Aufgabe wird mit einem mit akustischen Oberflächenwellen arbeitenden Reflektorfilter gelöst, das die im Patentanspruch 1 angegebenen Merkmale hat. Weitere vorteilhafte Ausgestaltungen eines solchen Filters gehen aus den Unteransprüchen hervor.

Unter "Oberflächenwellen" sind im Sinne der Erfindung in bzw. nahe der Oberfläche eines Festkörpers verlaufende akustische Wellen zu verstehen, die genauer spezifiziert als Rayleighwellen, Bleusteinwellen, SSBW-Wellen (surface skimming bulk waves) und dgl. bezeichnet werden und deren jeweiliges Auftreten eine Frage der Orientierung der Kristallrichtung des Substrats zur Anordnung der Oberflächenwellen-Strukturen ist.

Wichtige Merkmale der Erfindung sind die in bezug auf den Lauf der akustischen Wellen zwischen dem einen Eingangswandler und dem einen Ausgangswandler hintereinandergeschalteten zwei Reflektoren, deren von ihnen jeweils bewirkte Richtungsänderung in einem Winkelbereich größer etwa 155° und kleiner 180° liegt. Eintrittsrichtung und Austrittsrichtung der akustischen Welle eines jeweiligen Reflektors bilden also miteinander einen sehr spitzen Winkel.

Als eine weitere Ausgestaltung kann ein erstes Paar, bestehend aus zwei hintereinandergeschalteten Reflektoren, und ein zweites Paar ebenfalls hintereinandergeschalteter Reflektoren vorgesehen sein, wobei die zwei akustischen Wege dieser beiden Reflektorpaare in bezug auf den Eingangswandler und den Ausgangswandler zueinander parallel geschaltete Wege sind, d.h. die Reflektorpaare zu zwei voneinander unabhängigen akustischen Wegen gehören.

Jeder der zwei Reflektoren bzw. der drei Reflektoren des jeweiligen Paares bewirkt eine nahezu, aber auch nur nahezu, 180° Richtungsänderung der in den jeweiligen Reflektor hineinlaufenden akustischen Welle.

Da es sich um Filter handelt, ist mindestens einer der in einem akustischen Weg zwischen Eingangs- und Ausgangswandler liegenden wenigstens zwei Reflektoren gewichtet und/oder dispersiv ausgebildet.

Wie noch besser aus der nachfolgenden Figurenbeschreibung ersichtlich ist, ist infolge der zwei Reflektoren oder der Paare, bestehend aus je zwei Reflektoren, der akustische Weg zwischen Eingangswandler und Ausgangswandler des Filters ein Zick-Zack-bzw. "Z"-Weg. Solch ein Z-Weg besteht aus zwei zueinander parallelen Weganteilen, in denen die akustische Welle (lediglich parallel versetzt) in gleicher Richtung verläuft und dem diese Weganteile verbindenden spitzwinklig schräg verlaufenden dritten Weganteil. Die im Z-Weg enthaltenen zwei (spitzwinkligen) Richtungsänderungen (bewirkt durch die Reflektoren) ergeben eine Temperaturkompensation hinsichtlich temperaturabhängiger Reflexionswinkel.

Dieser Zick-Zack-Weg garantiert ein relativ geringes Maß an erforderlicher Größe des Substrats, nämlich etwa so wie bei einem eingangs beschriebenen Reflektorfilter der genannten US-PS.

Die erfindungswesentliche spitzwinklige Reflexion der akustischen Welle in den Reflektoren gewährleistet, daß der jeweilige Weg der akustischen Welle weitestgehend parallel einer einzigen ausgewählten Kristallrichtung des Substrats verläuft, nämlich weitestgehend parallel zur Haupt-Wellenausbreitungsrichtung des Eingangswandlers und des Ausgangswandlers. Bei Filtern der obengenannten US-A und EP-A ist wegen der 90° nahen Reflexionen ein Teil des Weges quer zur Richtung der Haupt-Wellenausbreitung der Wandler gerichtet.

Bei einem erfindungsgemäßen Reflektorfilter ist zu beachten, daß die zweifach sehr spitzwinklig reflektierte akustische Welle auf ihrem Weg zwischen Eingangswandler und Ausgangswandler auch durch jeweils denjenigen Bereich des Substrats hindurchläuft, in dem der Eingangs- und der Ausgangswandler auf der Substratoberfläche angeordnet ist.

Ein erfindungsgemäßes Filter kann sogar so ausgestaltet werden, daß es nur optimal geringen Verlust der Signalenergie hat. Die zwei hintereinandergeschalteten Reflektoren (auch die zwei Reflektoren eines jeweiligen Reflektorpaares einer nachfolgend noch näher zu beschreibenden Ausführungsform) sind schon wegen der etwa 155°- bis nur angenähert 180°-Rückreflexion in ihrem Reflexionsverhalten äußerst verlustarm, da bei der Erfindung deshalb im wesentlichen jeder Reflektorfinger des einen der beiden Reflektoren mit allen Reflektorfingern des anderen Reflektors (des betreffenden Paares) in Wechselwirkung tritt und umgekehrt.

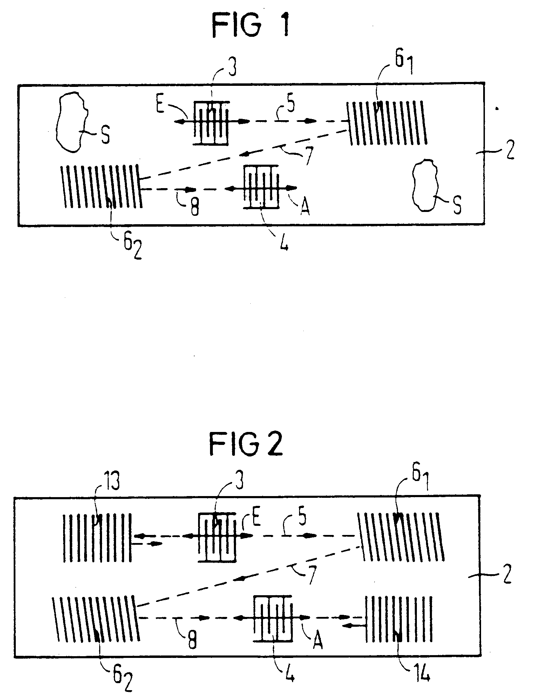

Durch Anordnung von Eingangswandler und Ausgangswandler in zwei benachbarten, zueinander parallelen Spuren ist das direkte akustische Übersprechen minimiert. Wenn man darüber hinaus auch noch diese Wandler innerhalb ihrer Spuren lateral zueinander versetzt, wie z.B. gemäß der Fig. 1, so wird bei der vorliegenden Erfindung auch ein mögliches Übersprechen durch eine 90° zur Hauptfortpflanzungsrichtung gerichtete Querwelle zusätzlich ausgeschlossen.

Bei einem erfindungsgemäßen Reflektorfilter sind Eingangswandler und Ausgangswandler so zueinander angeordnet, daß sich hinsichtlich der akustischen Welle Eingangswandler und Ausgangswandler nicht direkt "sehen". Jeglicher auftretender akustischer Weg zwischen diesen Wandlern verläuft über zwei spitzwinklige Reflexionen in den Reflektoren, d.h. geht zwangsläufig über gewichtete Reflektoren, deren Wichtung die vorgegebene Übertragungsfunktion des Reflektorfilters gewährleistet.

Weitere Erläuterungen der Erfindung gehen aus der Beschreibung der nachfolgenden Ausführungsbeispiele hervor.

Fig. 1 zeigt eine Prinzipdarstellung einer Ausführungsform der Erfindung.

Fig. 2 zeigt eine solche Darstellung einer ersten Weiterbildung.

Fig. 3 zeigt eine solche Darstellung einer zweiten Weiterbildung.

Fig. 4 zeigt eine praktische Ausführungsform eines Filters nach Fig. 3.

Fig. 5 zeigt eine praktische Ausführungsform eines Filters nach Fig. 1.

Fig. 6 zeigt eine Prinzipdarstellung einer Weiterbildung zum Filter nach Fig. 2 und

Fig. 7 zeigt eine Prinzipdarstellung einer Weiterbildung zum Filter nach Fig. 3.

Die Figuren 1 bis 3 zeigen schematisch prinzipielle Zuordnungen von Eingangswandler, Ausgangswandler und den zugehörigen Reflektoren zueinander. Das Filter der Fig. 1 hat auf einem mit seinem Umriß dargestellten Substrat 2 zwei Wandler 3, 4, von denen z.B. der Wandler 3 als Eingangswandler und der Wandler 4 als Ausgangswandler geschaltet sein können. Mit 5 ist der akustische Weg der vom Eingangswandler 3 ausgesandten Welle bezeichnet. Der Weg 5 ist parallel zur Haupt-Wellenausbreitungsrichtung E des Wandlers 3. Der Weg 5 führt in einen ersten Reflektor 6,1, an dessen entsprechend dem spitzen Reflexionswinkel etwas schräggestellten Reflektorfingern die Welle des Weges 5 in Richtung des Weges 7 zurückreflektiert wird. Die reflektierte Welle läuft also in Richtung des Weges 7 zu einem zweiten Reflektor 6,2, der hinsichtlich seiner Reflektorrichtung die Reflektionswirkung des Reflektors 6,1 so ausgleicht, daß eine im Reflektor 6,2 reflektierte Welle entsteht, die entlang dem Weg 8 in den Ausganswandler 4 gelangt. Die Wege 5 und 8 der akustischen Welle sind parallel zueinander und die Richtung des Weges 7 verläuft spitzwinklig zu den Wegen 5 und 8, nämlich so bemessen, daß die Richtungsänderung größer als 155° und kleiner als 180° ist. Eingangswandler und Ausgangswandler 3, 4 liegen auf benachbarten Haupt-Wellenausbreitungsrichtungen E,A wie dies die Fig. 1 zeigt. Mit S ist ein üblicher Sumpf zur Wellendämpfung bezeichnet.

Die Fig. 1 zeigt außerdem eine solche Anordnung der Wandler 3 und 4 zueinander, mit der diese beiden Wandler senkrecht zu ihren Haupt-Wellenausbreitungsrichtungen E, A gesehen, zueinander versetzt sind. Damit können orthogonal vom Eingangswandler 3 ausgesandte akustische (Quer-)Wellen nicht in den Ausgangswandler 4 gelangen, sondern laufen an diesem (senkrecht zu dessen Haupt-Wellenausbreitungsrichtung A gesehen) vorbei.

Fig. 2 zeigt eine ergänzte Ausführungsform der Fig. 1, nämlich mit je einem zusätzlichen Reflektor 13 und 14. Der Reflektor 13 hat (wie der Reflektor 6,3) zur Hauptwellenausbreitungsrichtung E des Eingangswandlers 3 senkrecht angeordnete Reflektorfinger.

Dieser Reflektor 13 dient dazu, vom Eingangswandler 3 (in der Fig. 2 nach links) ausgesandte akustische Wellen in und durch den Wandler 3 hindurch in den Reflektor 6,1 zurückzureflektieren. Die Kombination des Eingangswandlers 3 mit dem Reflektor 13 machen so den Eingangswandler 3 zu einem unidirektional wirkenden Wandler, der im Ergebnis seine gesamte Wellenenergie in den Reflektor 6,1 und weiter zu dem Ausgangswandler aussendet. Entsprechendes gilt für den zum Ausgangswandler 4 zusätzlichen Reflektor 14, der in diesem Reflektor 14 (in der Fig. 2 von links) gelangende akustische Wellen wieder nach links in den Ausgangswandler 4 zurückreflektiert. Bezüglich der Anordnung des Wandlers 3 und des Reflektors 13 zueinander bzw. des Wandlers 4 und des Reflektors 14 zueinander sind die bekannten Phasenbedingungen einzuhalten, damit der Wandler 3 eine verstärkte Welle aussendet bzw. der Wandler 4 die akustische Welle verstärkt empfängt.

Anstelle einer wie vorangehend beschriebenen Kombination kann jeweils auch ein Unidirektionalwandler nach der US-A-4 736 172 vorgesehen sein.

Fig. 3 zeigt schematisch eine weitere Ausgestaltung mit wiederum Eingangswandler 3 und Ausgangswandler 4 und vier Reflektoren auf dem Substrat 2. Die Wandler 3 und 4 wirken zusammen mit den Reflektoren 6,1 und 6,2 so wie dies zur Fig. 1 beschrieben ist. Die Reflektoren 6,11 und 6,12 sind weitere Reflektoren, die dazu dienen, vom Eingangswandler 3 entlang dem Weg 5,1 ausgehende akustische Wellen entlang dem Weg 7,1 in den Reflektor 6,12 und von diesem entlang dem Weg 8,1 in den Wandler 4 zu reflektieren. Zu einem gewissen Maße entspricht das Filter der Fig. 3 in seiner Effektivität dem Filter 3, da Eingangswandler und Ausgangswandler keine einseitigen Abstrahlungsverluste akustischer Welle haben.

Solche Filter der Fig. 2 und 3 bedürfen auch nicht zwingend irgendwelcher Dämpfungsmittel (Sumpf) wie dies z.B. für ein Filter der Fig. 1 linksseitig des Wandlers 3 (und rechtsseitig des Wandlers 4) der Fall ist.

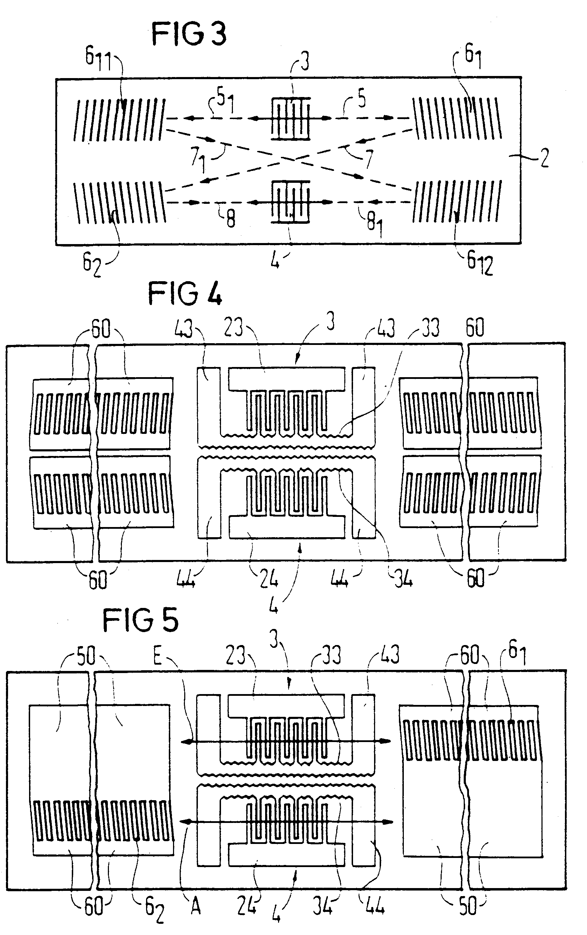

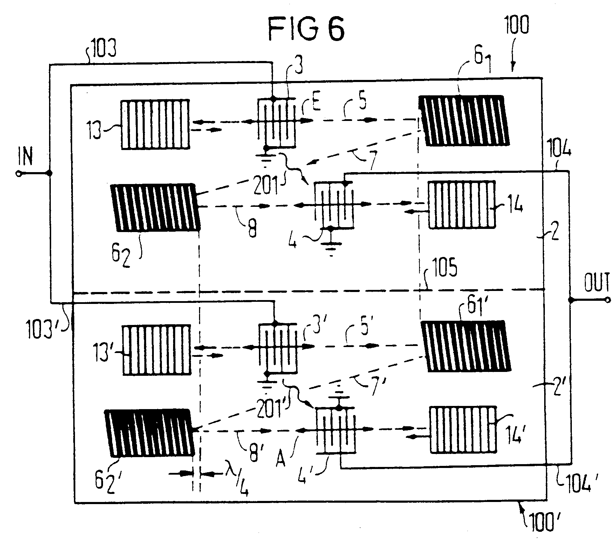

In detaillierterer Darstellung zeigt die Fig. 5 das Design eines Filters der Fig. 3. Die zur Fig. 3 bereits mit Bezugszeichen genannten Einzelheiten haben in Fig. 4 dieselbe Bedeutung. Mit 3 ist also wieder ein angenommenerweise als Eingangswandler betriebener Interdigitalwandler bezeichnet. Mit 23 ist die eine gleichzeitig als Anschlußpad dienende Sammelschiene der Interdigitalfinger des Wandlers 3 bezeichnet. Die andere Sammelschiene des Wandlers 3 ist mit 33 bezeichnet. Die Ränder dieser Sammelschiene 33 haben reflexionsmindernde geriffelte Struktur entsprechend dem Anspruch 7. Mit 43 sind Metallisierungsflächen entsprechend bezeichnet. Zu dem Interdigitalwandler 4 gehören die Sammelschienen 24 und 34, letztere wieder mit geriffelter Randstruktur und die Metallisierungsflächen 44. Die Reflektoren 6,1, 6,11, 6,2 und 6,12 haben jeweils in geringem Winkel zur Haupt-Wellenausbreitungsrichtung E bzw. A schräg ausgerichteter Reflektorfinger und seitlich angeordnete Metallisierungsflächen nach Art einer Sammelschiene.

Fig. 5 zeigt ein Design entsprechend dem Schema der Fig. 1. Bezüglich der Wandler 3 und 4 ist das Design übereinstimmend mit demjenigen der Fig. 4. Die Reflektoren 6,1 und 6,2 haben wiederum schräg gestellte Reflektorfinger. Mit 50 sind Zusatzmetallisierungsflächen auf der Oberfläche des Substrats bezeichnet, die außerhalb der Wandler und Reflektoren zur Egalisierung der Wellen-Ausbreitungsbedingungen vorgesehen sind.

Aufgabe einer Weiterbildung der Erfindung ist es, bei einem erfindungsgemäßen Filter zu erreichen, daß der Nutzsignal-/Störsignal-Abstand noch weiter verbessert ist.

Diese Aufgabe wird mit den Merkmalen des Anspruchs 9 gelöst und weitere vorteilhafte Ausgestaltungen gehen aus den Ansprüchen 10 bis 13 hervor.

Dieser Weiterbildung liegt der Gedanke zugrunde, vorzugsweise zwei, jedoch gegebenenfalls auch mehr als zwei erfindungsgemäße Oberflächenwellen-Reflektorfilter als Teilfilter des gesamten Filters der Weiterbildung miteinander elektrisch parallel geschaltet zu koppeln. Diese z. B. zwei parallel geschalteten Reflektorfilter dieses gesamten Filters können auf der Oberfläche ein und desselben Substrats realisiert sein. Es kann jedoch auch von Vorteil sein, zwei aufgetrennten Substraten angeordnete einzelne erfindungsgemäße Reflektorfilter miteinander parallel zu schalten. In beiden Fällen müssen sich jedoch diese beiden Filter in (einer) Einzelheit(en) unterscheiden, die aus den Patentansprüchen 8 bis 12 hervorgehen und die noch nachfolgend näher erläutert werden. Ansonsten sind diese beiden Filter, insbesondere hinsichtlich der Anordnung, Positionierung und Ausführung der Ein- und Ausführung der Ein- und Ausgangswandler jedes der Teilfilter, zueinander gleich.

Die vorliegende Weiterbildung beruht auf einer derartigen elektrischen Parallelschaltung (und den weiteren Maßnahmen), bei der durch phasenentgegengesetzte Addition der Störsignale jedes einzelnen der beiden Teil-Filter, diese im Ausgang des erfindungsgemäß weitergebildeten gesamten Filters kompensiert werden, jedoch das Nutzsignal der beiden miteinander parallel geschalteten Reflektorfilter sich addiert. Dabei spielt eine wesentliche Rolle, daß die beiden Filter prinzipiell gleich, d. h. bis auf einen jeweiligen Unterschied miteinander identisch sind, so daß bzw. damit die im jeweiligen Filter durch Übersprechen vom Eingang zum Ausgang übertragenen Störsignale (bis auf ihre jeweilige Phase, mit der sie am Ausgang des Filters auftreten) identisch sind. So können z. B. die Eingangswandler der beiden miteinander parallel geschalteten Teil-Filter vom Eingang des gesamten erfindungsgemäß weitergebildeten Filters her gesehen phasengleich parallel geschaltet sein und man sieht eine solche elektrische Verbindung der jeweiligen Ausgangswandler dieser beiden Teil-Filter vor, die, bezogen auf den Ausgang des gesamten Filters phasenentgegengesetzt ist. Dann heben sich die unvermeidlich übertragenen Störsignale im Ergebnis gegeneinander auf. Damit sich jedoch nicht auch das Nutzsignal aufhebt, unterscheiden sich diese beiden Teil-Filter darin, daß zwischen Eingangswandler und Ausgangswandler des einen Teil-Filters im Vergleich mit dem anderen Teil-Filter für das jeweilige Nutzsignal ein akustischer Wegunterschied des $(2n-1)$-fachen der halben Wellenlänge der akustischen Welle (des Nutzsignals) im Substratmaterial der Filter vorliegt, wobei $n$ eine natürliche Zahl, vorzugsweise 1, ist. Eine Alternative zu dieser Variante der Erfindung ist diejenige, bei der die elektrische Verbindung der Ausgänge der Ausgangswandler der beiden Teil-Filter phasengleich ist und die Eingangswandler, bezogen auf den Eingang des gesamten Filters, zueinander phasenentgegengesetzt verbunden sind.

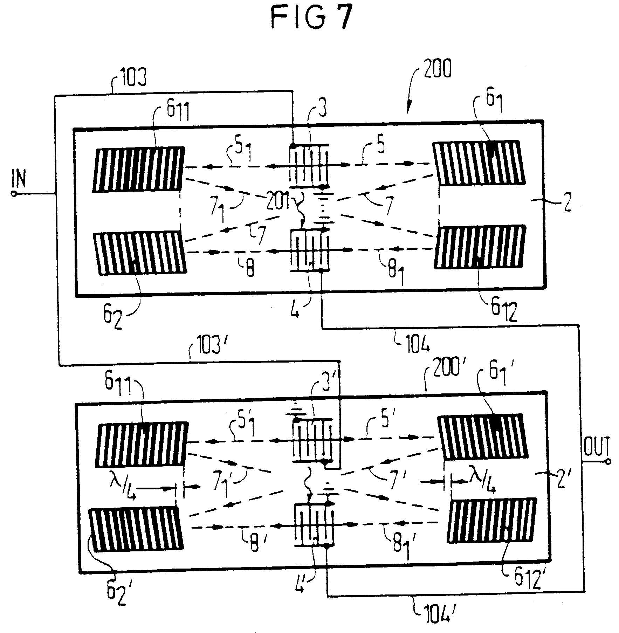

Figur 6 zeigt ein Filter gemäß Figur 2. Die in Figur 2 beschriebene Ausführungsform eines erfindungsgemäßen Oberflächenwellenfilters ist bei der vorliegenden Weiterbildung als Teil-Filter vorteilhaft zu verwenden ist. Für diese Weiterbildung als Teil-Filter zu verwenden, kommen aber auch die übrigen Ausführungsformen der Figuren 1 und 3 ohne weiteres in Betracht. Dabei ist zu beachten, daß ein Filter gemäß Figur 3 (enthalten in Figur 7) "Zwillingsausbildungen" ($5, 7, 8$ und $5_1, 7_1$ und $8_1$) der akustischen Wege des Nutzsignals hat, so daß die oben für die vorliegende Weiterbildung angegebene Bemessungsregel für den Wegunterschied $(2n-1)$ mal der halben Wellenlänge für das eine Teil-Filter gegenüber dem anderen Teil-Filter im gesamten Filter dieser Weiterbildung für diese beiden obengenannten "Zwillingswege" eingehalten sein muß.

Auch als Teil-Filter für die vorliegende Weiterbildung wenigstens der eine der zwei Reflektoren $6_1$ und/oder $6_2$ gewichtet und/oder dispersiv ausgebildet sein.

Figur 6 zeigt ein gesamtes Filter der Weiterbildung, und zwar mit zwei Teil-Filtern 100, 100' gemäß Figur 2, und zwar in einer ersten Variante mit elektrisch phasenentgegengesetzter Parallelschaltung der Ausgangswandler bei phasengleicher Parallelschaltung der Eingangswandler.

In Figur 6 ist das Substrat mit 2, 2' bezeichnet. Für das eine Teilfilter 100 ist für den Eingangswandler das Bezugszeichen 3 und für den Ausgangswandler das Bezugszeichen 4 gewählt. Mit $6_1$ und $6_2$ sind die zugehörigen Reflektoren und mit 5, 7 und 8 die angegebenen akustischen Teilwege des Nutzsignals im Teil-Filter 100 bezeichnet. Das andere Teil-Filter 100' hat den Eingangswandler 3', den Ausgangswandler 4', und die Reflektorstrukturen $6_1'$ und $6_2'$. Mit 103 und mit 103' sind die nicht auf Masse liegenden elektrischen Verbindungsleitungen zwischen dem Filtereingang IN und der "heißen" Sammelschiene der Eingangswandler 3, 3' bezeichnet. Die jeweils andere Sammelschiene der Wandler 3, 3' liegt (wie angedeutet) auf Masse. Ersichtlich sind die Eingangswandler 3, 3' elektrisch phasengleich parallelgeschaltet. Mit 104 und 104' sind die entsprechenden Verbindungsleitungen zwischen dem Filter-Ausgang OUT und den "heißen" Sammelschienen der Ausgangswandler 4 und 4' bezeichnet. Die jeweils anderen Sammelschienen der Ausgangswandler 4, 4' liegen (wie angedeutet) auf Masse. In der Figur 6 ist die elektrisch phasenentgegengesetzte Parallelschaltung der Ausgangswandler 4 und 4' ersichtlich. Mit 201 und 201' ist elektrisches und/oder akustisches Übersprechen innerhalb des Teil-Filters 100 bzw. innerhalb des Teil-Filters 100' angedeutet.

Die bei diesem Ausführungsbeispiel der Figur 6 vorgesehene phasenentgegengesetzte Parallelschaltung der Ausgangswandler 4, 4' (bei phasengleicher Parallelschaltung der Eingangswandler 3, 3') ergibt eine gegenseitige Aufhebung der Störsignale der Wege 201 und 201' am Ausgang OUT des Filters, wobei jedoch für die Weiterbildung vorausgesetzt ist, daß die Anordnung und Positionierung einerseits der Wandler 3 und 4 zueinander und andererseits der Wandler 3' und 4' zueinander so identisch ist, daß Phasenunterschiede zwischen den Wegen 201 und 201' praktisch nicht auftreten.

Damit dieses gegenseitige Aufheben jedoch für die Nutzsignale der Wege 5, 7, 8 einerseits gegenüber den Wegen 5', 7', 8' andererseits nicht auftritt, ist der eine dieser akustischen Wege um das $(2n - 1)$-fache der halben Wellenlänge der akustischen Welle unterschiedlich groß gewählt, wobei $n = 1$ bevorzugt ist. In der Figur 6 ist dieser Längenunterschied durch den Versatz der Reflektorstruktur $6_2'$ im Teilfilter 100' gegenüber der Positionierung der Reflektorstruktur $6_2$ im Teil-Filter 100 kenntlich gemacht. Wegen des doppelten Weges der reflektierten Strahlung ist dort ein Versatz von einem Viertel der Wellenlänge vorzusehen. Um dieses Maß ist die Reflektorstruktur $6_2'$ in Figur 6 (gegenüber der Reflektorstruktur $6_2$) nach links verschoben. Es ist dies ein wenig auffallender Unterschied der Teil-Filter 100 und 100' voneinander, der aber zusammen mit der schon erwähnten identischen Anordnung und Positionierung der Wandler 3, 4 bzw. 3', 4' für die Weiterbildung wichtig ist.

Der Wegunterschied für das Nutzsignal kann auch durch Verkürzung des Weges im Teil-Filter 100' bewirkt sein. Es kann auch vorgesehen sein, daß die Reflektorstruktur $6_1'$ entsprechend verschoben positioniert ist. Im übrigen können diesbezüglich das Teil-Filter 100 und das Teil-Filter 100' miteinander vertauscht sein.

Eine Variation der Weiterbildung besteht darin, die Eingangswandler 3, 3' der beiden Teilfilter bezogen auf den Eingang IN phasenentgegengesetzt parallel zu schalten und die Ausgangsfilter 4, 4' phasengleich parallel zu schalten in bezug auf den Ausgang OUT. Auch in diesem Falle ist die Einhaltung der oben erörterten Bedingungen bezüglich der Anordnung und Positionierung der Wandler 3 und 4 bzw. 3' und 4' zueinander wichtig, damit dort keine gegenseitigen Phasenunterschiede auftreten.

Ansich kann die Weiterbildung auch dadurch realisiert werden, daß gerade diese Übertragungswege 201 und 201' des Störsignals einen 180°-Phasenunterschied aufweisen und die Wandler 3 und 3' bzw. 4 und 4' sind bezogen auf den Eingang und den Ausgang des Filters in identischer Weise jeweils parallel geschaltet. Diese mögliche weitere Ausführungsform der Weiterbildung ist aber auf jeden Fall nicht in allen Fällen so günstig, wie die Ausführungen mit phasengleicher/phasenentgegengesetzter Parallelschaltung der Eingangswandler/Ausgangswandler (wie in Figur 6 dargestellt).

Die voranstehend beschriebenen Variationen der Weiterbildung können noch in weiter zweierlei Weise realisiert sein, nämlich man ordnet die Strukturen der beiden Teil-Filter 100, 100' auf ein und demselben Substrat 2, 2' an, wie dies die Figur 6 zeigt. Die gestrichelte Linie 105 deutet jedoch darauf hin, daß auch zwei einzelne Substrate 2 und 2' vorgesehen sein können. Diese bezüglich ihres Substrats voneinander getrennten Teilfilter 100, 100' können in einer entsprechenden Schaltungsanordnung auch räumlich voneinander getrennt angeordnet sein, nämlich solange, wie die für die Weiterbildung oben beschriebenen Bedingungen, insbesondere auch hinsichtich der Wege 201 und 201', eingehalten sind. Bei räumlicher Trennung ist zu beachten, daß auch weitere Fremdeinflüsse, z. B. Magnetfelder, die Einhaltung der oben angegebenen Bedingungen bezüglich der Wege 201 und 201' beeinträchtigen können.

Die Figur 7 zeigt eine Ausführungsform mit zwei Teil-Filtern 200, 200', die jedes für sich einem Filter der erfindungsgemäßen Ausführungsform der Figur 3 gleich sind. Das Teil-Filter 200 hat die mit der Figur 1 übereinstimmenden Einzelheiten, die die schon zur Figur 1 beschriebenen Bezeichnungen haben. Mit $6_{11}$ und $6_{12}$ sind zwei weitere Reflektorstrukturen bezeichnet, die statt der Reflektorstrukturen 13 und 14 vorgesehen sind. Die Reflektorstrukturen $6_{11}$ und $6_{12}$ reflektieren in genau der gleichen Weise wie die Reflektorstrukturen $6_1$ und $6_2$ die vom Eingangswandler 3 in der Haupt-Wellenausbreitungsrichtung E verlaufende akustische Strahlung mit dem zusätzlichen Nutzsignalweg $5_1$, $7_1$ und $8_1$. Gemäß der Erfindung superponieren sich die Nutzsignale der Wege 5, 7 und 8 einerseits und $5_1$, $7_1$, und $8_1$ andererseits in dem Ausgangswandler 4 zum Ausgangs-Nutzsignal.

Das zweite Teil-Filter 200' der Ausführungsform der Figur 7 ist bis auf den erfindungsgemäß vorgesehenen Weglängenunterschied für das Nutzsignal identisch mit dem Teil-Filter 200. Die mit " ' " versehenen Bezugszeichen der Einzelheiten des Teil-Filters 200' haben die Bedeutung der entsprechenden Einzelheiten des Teil-Filters 200. Auch für die Teil-Filter 200 und 200' gilt, daß die Anordnung und Positionierung der Eingangswandler und Ausgangswandler (3 und 4 bzw. 3' und 4') zueinander identisch ist und daß der Nutzsignalweg im Teil-Filter 200' sich um das $(2n - 1)$-fache der halben Wellenlänge der akustischen Welle unterscheidet, wobei im vorliegenden Falle dieser Unterschied für die beiden Nutzsignalwege der Teilfilter 200 und 200' erfüllt sein muß, d. h., daß die Nutzsignalwege 5', 7' und 8' einerseits und $5_1'$, $7_1'$ und $8_1'$ einander gleich sind (oder sich nur um ganze Vielfache der Wellenlänge unterscheiden) sich aber von den Nutzsignalwegen 5, 7 und 8 bzw. $5_1$, $7_1$ und $8_1$ (die vorzugsweise wiederum gleich lang sind oder sich um nur ganze Vielfache der Wellenlänge unterscheiden) um jeweils das $(2n - 1)$-fache der halben Wellenlänge der akustischen Welle im Material des Substrats unterscheiden.

Konstruktive Aufbauten der Teil-Filter 100, 100'bzw. 200, 200' können vorzugsweise wie den Ausführungen der Figuren 5 und 6 entsprechend realisiert sein.

Auch bei der vorliegenden Weiterbildung können in dem gesamten weitergebildeten Filter (Figuren 6 und 7) in den Teil-Filtern die Eingangswandler und Ausgangswandler in Richtung ihrer jeweiligen Haupt-Wellenausbreitungsrichtung lateral gegeneinander versetzt angeordnet sein, um auch auf diese Weise Übersprechen durch Querwellen zu mimieren. Die Eingangswandler und/oder Ausgangswandler können unidirektional wirkende Wandler sein, wie in Figur 6. Auch bei der vorliegenden Weiterbildung können Zusatzmetallisierungsflächen auf der Oberfläche des Substrats außerhalb der Wandler und Reflektorstrukturen zur Egalisierung der Wellen-Ausbreitungsbedingungen vorgesehen sein. Mit der Maßnahme, auf der Oberfläche des Substrats einander gegenüberliegende Kanten der Sammelschienen von Wandlern und/oder Reflektoren mit geriffelter Struktur zu versehen, so daß Totalreflexion einer akustischen Welle an einer derartigen geriffelten Kante ausgeschlossen ist, kann auch für die vorliegende Weiterbildung von Vorteil sein.

Die Parallelschaltungen sind jeweils unsymmetrisch. Die Eingangs- bzw. Ausgangswandler können auch für symmetrischen Eingang IN bzw. Ausgang OUT verbunden und geschaltet sein.

**Patentansprüche**

1. Mit akustischen Oberflächenwellen arbeitendes Reflektorfilter mit:
   einem Eingangswandler (3) mit einer Haupt-Wellenausbreitungsrichtung (E)
   einem Ausgangswandler (4) mit einer Haupt-Wellenausbreitungsrichtung (A),
   einem Substrat (2), auf dessen Oberfläche diese Eingangs- und Ausgangswandler derart angeordnet sind,
   daß kein Zusammenfallen von Eingangswandler-Haupt-Wellenausbreitungsrichtung (E) und Ausgangswandler-Haupt-Wellenausbreitungsrichtung (A) vorliegt,
   mit zwei hinsichtlich des jeweiligen akustischen Weges (5;7;8; 5,1;7,1;8,1) zwischen dem Eingangswandler (3) und dem Ausgangswandler (4) hintereinandergeschalteten Reflektoren (6,1;6,2;), die zu den Wandlern (3;4) und zueinander derart angeordnet sind, daß die akustische Welle zwischen den Wandlern (3;4) zwei hintereinandergeschaltete Richtungsänderungen um jeweils einen dem Betrag nach gleichen Winkel hat, und diese Richtungsänderungen der akustischen Welle in einem jeweiligen solchen Reflektor größer als 155° und kleiner als 180° ist, sodaß sich ein im wesentlichen Z-förmiger bzw. spiegelverkehrt Z-förmiger Wellenausbreitungsweg (5,7,8) vom Eingangswandler (3) zum Ausgangswandler (4) ergibt.

2. Reflektorfilter nach Anspruch 1,
   **gekennzeichnet dadurch,**
   daß Eingangswandler und Ausgangswandler in Richtung ihrer jeweiligen Haupt-Wellenausbreitungsrichtung lateral mindestens so weit gegeneinander versetzt angeordnet sind, daß Übersprechen durch Querwellen vermieden ist.

3. Reflektorfilter nach Anspruch 1 oder 2,
   **gekennzeichnet dadurch,**
   daß Eingangswandler und/oder Ausgangswandler unidirektionale Wandler sind.

4. Reflektorfilter nach Anspruch 3,
   **gekennzeichnet dadurch,**
   daß für die unidirektionale Wirkung des Wandlers (3,4) für einen jeweiligen Wandler ein zusätzlicher 180°-Reflektor (13,14) vorgesehen ist, der bezogen auf den jeweiligen Wandler in Richtung der Haupt-Wellenausbreitungsrichtung entgegengesetzt einem der hintereinandergeschalteten Reflektoren (6, 1; 6, 2) angeordnet ist.

5. Reflektorfilter nach Anspruch 3,
   **gekennzeichnet dadurch,**
   daß der jeweilige Unidirektional-Wandler ein Mehrphasen-Wandler ist.

6. Reflektorfilter nach einem der Ansprüche 1 bis 5,
   **gekennzeichnet dadurch,**
   daß Zusatzmetallisierungsflächen (50) auf der Oberfläche des Substrats (2) außerhalb der Wandler (3,4) und Reflektoren (6,1;6,2) zur Egalisierung der Wellen-Ausbreitungsbedingungen vorgesehen sind.

7. Reflektorfilter nach Anspruch 1 oder 2,
   **gekennzeichnet dadurch,**
   daß zum Eingangswandler (3) und Ausgangswandler (4) doppelte akustische Weg (5;7;8;5,1;7,1;8,1) zu jeweils beiden Enden der Wandler (3,4) vorgesehen sind,
   wobei in jedem dieser doppelt auftretenden Wege hintereinandergeschaltet zwei Reflektoren (6,1;6,2;6,11;6,12) angeordnet sind die diese Richtungsänderungen bewirken.

8. Reflektorfilter nach einem der vorangehenden Ansprüche 1-7,
   **gekennzeichnet dadurch,**
   daß auf der Oberfläche des Substrats einander gegenüberliegende Kanten der Sammelschiene (33,34) von Wandlern (3,4) und/oder Reflektoren geriffelte Struktur derart haben, daß Totalreflexion einer akustischen Welle an einer derartigen geriffelten Kante ausgeschlossen ist.

9. Oberflächenwellen-Reflektorfilter nach einem der Ansprüche 1 bis 8,
**gekennzeichnet dadurch,**
daß für weiter verbesserten Nutzsignal-/Störsignalabstand zwei derartige Filterstrukturen mit gleichem Aufbau als Teil-Filter (100, 100′, 200, 200′) elektrisch parallel geschaltet sind derart, daß die jeweiligen Ausgangs- bzw. Eingangs-Wandler (4, 4′) bzw. (3, 3′) phasenentgegengesetzt elektrisch miteinander verbunden sind und die Eingangs- bzw. Ausgangs- Wandler (3, 3′) bzw. (4, 4′) phasengleich elektrisch miteinander verbunden sind, daß der akustische Weg (5′, 7′, 8′) des Nutzsignals zwischen Eingangswandler und Ausgangswandler (3′, 4′) in dem einen Teil-Filter (100′ , 200′) durch Position der Reflektoren ($6_2′$, $6_{12}′$) um das (2n - 1)-fache der halben Wellenlänge der akustischen Welle im Material des Substrats bei der Mittenfrequenz des Filters unterschiedlich ist gegenüber dem akustischen Weg (5, 7, 8) des Nutzsignals im anderen Teil-Filter (100, 200) und daß die Anordnung und Position von Eingangswandler und Ausgangswandler (3, 4) zueinander im einen Teil-Filter (100, 200) identisch ist mit der Zueinanderanordnung und -position von Eingangswandler und Ausgangswandler (3′, 4′) im anderen Teil-Filter (100′, 200′).

10. Reflektorfilter nach Anspruch 9,
**gekennzeichnet dadurch,**
daß (13, 14,...) unidirektional wirksame Eingangs-/Ausgangswandler vorgesehen sind.

11. Reflektorfilter nach Anspruch 9,
**gekennzeichnet dadurch,**
daß zwei Teil-Filter (200, 200′) mit jeweils doppeltem akustischen Weg (5, 7, 8) und ($5_1$, $7_1$ und $8_1$) vorgesehen sind.

12. Reflektorfilter nach einem der Ansprüche 9 bis 11,
**gekennzeichnet dadurch,**
daß die Strukturen beider Teil-Filter (100, 100′) auf einem einstückigen Substrat (2 mit 2′) vorgesehen sind.

13. Reflektorfilter nach einem der Ansprüche 9 bis 11,
**gekennzeichnet dadurch,**
daß jedes der Teil-Filter (200, 200′) auf je einem eigenen Substrat (2 und 2′) realisiert ist und diese Teil-Filter nur elektrisch zusammengeschaltet verbunden sind.

**Claims**

1. Reflector filter operating with surface acoustic waves, having
   an input transducer (3) with one main wave propagation direction (E),
   an output transducer (4) with one main wave propagation direction (A),
   a substrate (2), on the surface of which said input and output transducers are arranged in such a way that there is no coincidence of input transducer main wave propagation direction (E) and output transducer main wave propagation direction (A),
   having two reflectors (6,1; 6,2;) connected in series with respect to the respective acoustic path (5; 7; 8; 5,1; 7,1; 8,1) between the input transducer (3) and the output transducer (4), which reflectors are arranged relative to the transducers (3; 4) and to one another in such a way that the acoustic wave between the transducers (3; 4) has two series-connected changes of direction in each case by an angle that is identical with respect to amount, and said changes of direction of the acoustic wave in such a respective reflector are greater than 155° and less than 180°, so that an essentially Z-shaped or inverted Z-shaped wave propagation path (5, 7, 8) is produced from the input transducer (3) to the output transducer (4).

2. Reflector filter according to Claim 1, characterized in that input transducer and output transducer are arranged with at least such a wide lateral offset with respect to one another in the direction of their respective main wave propagation direction that crosstalk as a result of transverse waves is avoided.

3. Reflector filter according to Claim 1 or 2, characterized in that input transducer and/or output transducer are unidirectional transducers.

4. Reflector filter according to Claim 3, characterized in that, for the unidirectional effect of the transducer (3, 4), an additional 180° reflector (13, 14) is provided for a respective transducer which, in relation to the respective transducer, is arranged in the direction of the main wave propagation direction counter to one of the series-connected reflectors (6,1; 6,2).

5. Reflector filter according to Claim 3, characterized in that the respective unidirectional transducer is a multi-phase transducer.

6. Reflector filter according to one of claims 1 to 5, characterized in that additional metallization surfaces (50) are provided on the surface of the substrate (2) outside the transducers (3, 4) and reflectors (6,1; 6,2) for equalizing the wave propagation conditions.

7. Reflector filter according to Claim 1 or 2, characterized in that there are provided to the input transducer (3) and output transducer (4) dual acoustic paths (5; 7; 8; 5,1; 7,1; 8,1) to the two ends of the transducers (3, 4) in each case, wherein there are arranged in each of these dual paths occurring two series-connected reflectors (6,1; 6,2; 6,11; 6,12) which bring about said changes of direction.

8. Reflector filter according to one of the preceding claims 1 to 7, characterized in that mutually opposite edges of the busbar (33, 34) of transducers (3, 4) and/or reflectors on the surface of the substrate have a corrugated structure such that total reflection of an acoustic wave at such a corrugated edge is pre-cluded.

9. Surface-wave reflector filter as claimed in one of Claims 1 to 8, characterized in that, for a further improved ratio of wanted signal to interference signal, two such filter structures having the same construction are connected electrically parallel as partial filters (100, 100', 200, 200') in such a way that the respective output or input transducers (4, 4') or (3, 3') respectively are electrically connected to one another with opposite phase, and the input or output transducers (3, 3') or (4, 4') respectively are electrically connected to one another with equal phase, in that the acoustic path (5', 7', 8') of the wanted signal between input transducer and output transducer (3', 4') in the one partial filter (100', 200'), by position of the reflectors ($6_2'$, $6_{12}'$) in the material of the substrate at the mid-frequency of the filter, differs from the acoustic path (5, 7, 8) of the wanted signal in the other partial filter (100, 200) by (2n - 1) times half the wavelength of the acoustic wave, and in that the arrangement and position of input transducer and output transducer (3, 4) relative to one another in the one partial filter (100, 200) are identical to the mutual arrangement and position of input transducer and output transducer (3', 4') in the other partial filter (100', 200').

10. Reflector filter according to Claim 9, characterized in that (13, 14, ...) unidirectional input/output transducers are provided.

11. Reflector filter according to Claim 9, characterized in that two partial filters (200, 200') are provided with in each case a dual acoustic path (5,

7, 8) and ($5_1$, $7_1$ and $8_1$).

12. Reflector filter as claimed in one of claims 9 to 11, characterized in that the structures of both partial filters (100, 100') are provided on a single-piece substrate (2 with 2').

13. Reflector filter as claimed in one of claims 9 to 11, characterized in that each of the partial filters (200, 200') is realized on its own substrate (2 and 2') in each case and said partial filters are only connected together electrically.

## Revendications

1. Filtre réflecteur coopérant avec des ondes acoustiques de surface, comprenant :
un convertisseur ou transducteur d'entrée (3) possédant une direction principale (E) de propagation des ondes,
un convertisseur ou transducteur de sortie (4) possédant une direction principale (A) de propagation des ondes,
un substrat (2), sur la surface duquel ces convertisseurs d'entrée et de sortie sont disposés de telle sorte
qu'il ne se produit aucune convergence entre la direction principale (E) de propagation des ondes du convertisseur d'entrée et la direction principale (A) de propagation des ondes du convertisseur de sortie,
deux réflecteurs (6,1;6,2), qui sont disposés l'un derrière l'autre sur le trajet acoustique respectif (5;7;8;5,1;7,1;8, 1) entre le convertisseur d'entrée (3) et le convertisseur de sortie (4) et qui sont disposés par rapport aux convertisseurs (3;4) et les uns par rapport aux autres de telle sorte que l'onde acoustique possède, entre les convertisseurs (3;4), deux changements de direction exécutés l'un derrière l'autre correspondant respectivement à un même angle en valeur absolue, et que ces changements de direction de l'onde acoustique sont, dans un tel réflecteur respectif, supérieurs à 155°C et inférieurs à 180°, de sorte qu'on obtient un trajet (5,7,8) de propagation des ondes essentiellement enforme de Z ou en forme de Z renversé symétrique depuis le convertisseur d'entrée (3) jusqu'au convertisseur de sortie (4).

2. Filtre réflecteur suivant la revendication 1, caractérisé par le fait que les directions principales respectives de propagation des ondes du convertisseur d'entrée et du convertisseur de sortie sont réciproquement décalées latéralement au moins de telle sorte qu'une diaphonie par des ondes transversales est évitée.

3. Filtre réflecteur suivant la revendication 1 ou 2, caractérisé par le fait que le convertisseur d'entrée et/ou le convertisseur de sortie sont des convertisseurs unidirectionnels.

4. Filtre réflecteur suivant la revendication 3, caractérisé par le fait que pour l'effet unidirectionnel du convertisseur (3,4), il est prévu, pour chaque convertisseur, un réflecteur à 180° supplémentaire (13,14), qui est disposé, par rapport au convertisseur respectif, à l'opposé de l'un des réflecteurs (6,1; 6,2) disposés l'un derrière l'autre, dans la direction principale de propagation des ondes.

5. Filtre réflecteur suivant la revendication 3, caractérisé par le fait que le convertisseur unidirectionnel respectif est un convertisseur polyphasé.

6. Filtre réflecteur suivant l'une des revendications 1 à 5, caractérisé par le fait que les surfaces de métallisation supplémentaires (50) sont prévues sur la surface du substrat (2) à l'extérieur des convertisseurs (3,4) et des réflecteurs (6,1; 6,2) pour l'égalisation des conditions de propagation des ondes.

7. Filtre réflecteur suivant la revendication 1 ou 2, caractérisé par le fait qu'il est prévu en rapport avec le convertisseur d'entrée (3) et le convertisseur de sortie (4), des trajets acoustiques doublés (5;7,8;5,1;7,1;8,1) jusqu'aux deux extrémités respectives des convertisseurs (3,4), et dans chacun de ces trajets doublés sont disposés, l'un derrière l'autre, deux réflecteurs (6,1; 6,2; 6,11;6,12) qui provoquent ces changements de direction.

8. Filtre réflecteur suivant l'une des revendications précédentes 1-7, caractérisé par le fait que des bords, qui sont situés à l'opposé l'un de l'autre sur la surface de support, des rails collecteurs (33,34) de convertisseurs (3,4) et/ou de réflecteurs possèdent une structure nervurée de telle sorte qu'une réflexion totale d'une onde acoustique sur un tel bord nervuré est exclue.

9. Filtre réflecteur à ondes de surface suivant l'une des revendications 1 à 8, caractérisé par le fait que pour l'obtention d'un rapport signal bruit amélioré de façon supplémentaire, de telles structures de filtres possédant le même agencement sont branchées électriquement en parallèle en tant que filtres partiels (100,100',200,200') de telle sorte que les convertisseurs respectifs de sortie ou d'entrée (4,4') ou (3,3') sont reliés électriquement entre eux en opposition de phase et que les convertisseurs d'entrée et de sortie (3,3; 4,4') sont reliés électriquement entre eux en phase, que le trajet acoustique (5',7',8') du signal utile entre le convertisseur d'entrée et le convertisseur de sortie (3',4') dans un filtre partiel (100',200') diffère du trajet acoustique (5,7,8) du signal utile dans l'autre filtre partiel (100,200), en raison de la position des réflecteurs ($6_2'$, $6_{12}'$), d'une valeur égale à (2n-1) fois la demi-longueur d'onde de l'onde acoustique dans le matériau du substrat pour la fréquence centrale du filtre, et que la disposition et la position réciproques du convertisseur d'entrée et du convertisseur de sortie (3,4) dans un filtre partiel (100,200) sont identiques à la disposition et à la position relatives du convertisseur d'entrée et du convertisseur de sortie (3',4') dans l'autre filtre partiel (100', 200').

10. Filtre réflecteur suivant la revendication 9, caractérisé par le fait qu'il est prévu des convertisseurs d'entrée/sortie à effet unidirectionnel (13,14,...).

11. Filtre réflecteur suivant la revendication 9, caractérisé par le fait qu'il est prévu deux filtres partiels (200,200') possédant respectivement des trajets acoustiques doublés (5,7,8) et ($5_1,7_1$ et $8_1$).

12. Filtre réflecteur suivant l'une des revendications 9 à 11, caractérisé par le fait que les structures des deux filtres partiels (100, 100') sont prévues sur un substrat monobloc (2 avec 2').

13. Filtre réflecteur suivant l'une des revendications 9 à 11, caractérisé par le fait que chacun des filtres partiels (200, 200') est formé respectivement sur un substrat particulier (2 et 2') et que ces filtres partiels sont interconnectés uniquement électriquement.

## FIG 1

## FIG 2

# FIG 3

# FIG 4

# FIG 5

EP 0 571 365 B1

# FIG 6

# FIG 7